# EUROPEAN PATENT SPECIFICATION

(11) **EP 1 120 811 B1**
(45) Date of publication and mention of the grant of the patent: **01.12.2004**
(21) Application number: 01300564.0
(22) Date of filing: 23.01.2001
(51) Int. Cl.: H01J 37/34

(54) **Planar-type magnetron sputtering apparatus**
Flaches Magnetron-Zerstäubungsgerät
Appareil plan de pulvérisation magnétron

(30) Priority: 24.01.2000 KR 2000003269
(43) Date of publication of application: 01.08.2001
(73) Proprietor: Sungkyunkwan University, Jongro-gu, Seoul 110-745 (KR)
(72) Inventor: Han, Jeon-geon, Songpa-gu, Seoul (KR); Nam, Kyung-hoon, Yangchun-gu, Seoul (KR); Musil, Jindrich, Machova 659 (CZ)
(74) Representative: Davies, Gregory Mark

(56) References cited:
- EP-A- 0 451 642
- JP-A- 60 007 132
- US-A- 4 526 643

## Description

### BACKGROUND OF THE INVENTION

### Field of the Invention

The present invention relates to an apparatus for physically forming a thin coating on a substrate surface through a sputtering process and, more particularly, to a planar-type magnetron sputtering apparatus capable of forming a uniform thin coating on the entire surface of a substrate having a large area.

### Description of the Prior Art

As well known to those skilled in the art, a magnetron sputtering process has been used for forming a thin coating on a substrate surface. Since such a magnetron sputtering process is advantageous in that it can be performed at a lower temperature environment and can effectively form a thin coating having a desired appearance on a substrate surface, it has been widely used in the sputtering field.

The conventional magnetron sputtering process is a kind of physical vapor deposition process, which increases both the ionization ratio and the sputtering ratio at a position around a target. The conventional magnetron sputtering process thus provides a thin coating deposited on a substrate surface with a high adherent force, a desired surface and a high density of the coating.

When both an electric field and a magnetic field are formed around a target so as to allow the target to perform a magnetron discharge, electrons are discharged from the target while creating both a swirling motion and a hopping motion at a position around a predetermined portion of the target surface in accordance with the electric field, the magnetic field and the velocity of discharged electrons. In such a case, both the ionization ratio and the sputtering ratio are increased at the portion of the target with partially concentrated electrons. Therefore, it is necessary to properly control the electric field and the magnetic field during a magnetron sputtering process so as to use the target as a highly efficient magnetron coating source. Of the two fields, it is particularly important to properly control the magnetic field during a sputtering process.

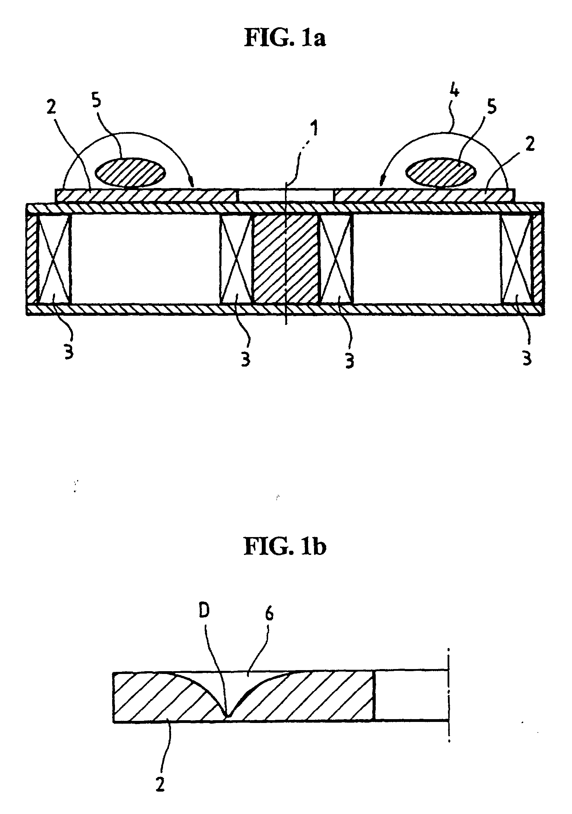

Fig. 1a is a sectional view, showing the construction of a conventional planar-type magnetron sputtering apparatus. As shown in the drawing, the conventional planar-type magnetron sputtering apparatus forms one large-scaled elliptical magnetic field closed circuit 4 around the surface of a cathode target 2 using a permanent magnet 3. A magnetron discharge track is formed along the closed circuit 4, and so the target 2 is partially sputtered and etched at a portion corresponding to the discharge track.

However, the magnetron discharge track formed by the permanent magnet 3 is a fixed track, and so the target 2 is undesirably and partially etched at a position around an area 5 with a high density plasma. The etching rate is also partially accelerated at the position 6 of the target 2 around said area 5. Therefore, the target 2 is concentratively etched at said position 6 around the area 5, thus forming a V-shaped etching valley "D" as best seen in Fig. 1b. When such a conventional magnetron sputtering apparatus is used for forming a thin coating on the entire surface of a substrate having a large area, it is almost impossible to form a uniform coating. In addition, the partially and heavily etched target 2 of Fig. 1b is not usable in a next sputtering process, and so the conventional magnetron sputtering apparatus excessively wastes targets such that it only provides a low target using efficiency of no higher than 30%.

US 4 526 643, discusses a dry etching apparatus having a plurality of magnets arranged on the outside of a housing to generate magnetic fields around a cathode electrode. The plurality of magnets is moved along an endless elliptical track in one direction parallel to the surface of the target resulting in the magnetic field being moved in one direction on the cathode electrode. However, there are limitations to the control of the magnetic field during sputtering.

In an effort to overcome such problems experienced by the conventional magnetron sputtering apparatus, somewhat improved magnetron sputtering apparatuses capable of improving both the target using efficiency and the uniformity of a thin coating deposited on a substrate surface have been proposed as disclosed in U.S. Patent Nos. 5,873,989 and 5,855,744. In the above U.S. sputtering apparatuses, a plurality of magnetic field closed circuits are formed around the surface of a cathode target using a plurality of permanent magnets, thus creating a plurality of magnetron discharge tracks on the entire surface of the target. The magnetic field closed circuits are also designed to move in opposite directions along the target while retaining their parallel spaces from the target surface, thus allowing the magnetron discharge tracks to move on the entire surface of the target in the same directions as those of the closed circuits. The U.S. sputtering apparatuses thus improve the uniformity of the thin coating deposited on the surface of the substrate in addition to improving the target using efficiency.

In the above U.S. magnetron sputtering apparatuses with the movable closed circuits, the opposite directional movement of said closed circuits is accomplished by either the rotating force of a motor-operated screw or the rotating force of a motor-operated eccentric shaft.

However, such a magnetron sputtering apparatus with the movable closed circuits is problematic in that it is almost impossible to move the permanent magnet closed circuits at desired high speeds during an opposite directional movement of the closed circuits. In addition, in order to accomplish the opposite directional movement of the permanent magnet closed circuits, each of said sputtering apparatuses necessarily uses a reversible motor, which must repeatedly and frequently change its rotating direction during operation of the sputtering apparatus. However, the reversible motor is easily overloaded and this reduces its expected life span.

The closed circuits are also repeatedly and temporarily stopped at the time the reversible motor changes it rotating direction, and so the magnetron discharge time at opposite end portions of the target is longer than that of the middle portion of the target. Therefore, the sputtering apparatuses only provide an inferior uniformity of the thin coating deposited on the substrate surface and an inferior target efficiency of no higher than 50%.

Furthermore, the reversible motor is rotated at a constant velocity, while there is a difference in the linear velocity of the eccentric shaft during a movement of the eccentric shaft, thus causing the magnetron discharge time at the end portions of the target to be longer than that of the middle portion of the target. Therefore, the U.S. sputtering apparatuses cannot uniformly etch the target or accomplish a desired uniformity of the thin coatings deposited on the substrate surfaces.

### SUMMARY OF THE INVENTION

According to the present invention, there is provided a planar-type magnetron sputtering apparatus according to claim 1.

The present invention has been made keeping in mind the above problems occurring in the prior art, and an object of an embodiment of the present invention is to provide a planar-type magnetron sputtering apparatus, which effectively forms a uniform thin coating on the entire surface of a substrate having a large area.

Another object of an embodiment of the present invention is to provide a planar-type magnetron sputtering apparatus, which improves the target using efficiency during a sputtering process.

A further object of an embodiment of the present invention is to provide a planar-type magnetron sputtering apparatus, which lengthens the expected life span of a means for moving the permanent magnets during an operation of the sputtering apparatus.

Still another object of an embodiment of the present invention is to provide a planar-type magnetron sputtering apparatus, which is designed to allow a target to be uniformly etched for the same discharge time regardless of the portions of the target from one end to the other end of said target during a sputtering process.

In order to accomplish the above objects, the present invention provides an embodiment of a planar-type magnetron sputtering apparatus, comprising a target seat used for seating and holding a target, selected from metal targets of titanium (Ti), chrome (Cr), aluminum (Al), copper (Cu) or zirconium (Zr), or ceramic targets of indium tin oxide (ITO) or aluminum oxide (Al₂O₃), thereon in addition to insulating the target from surrounding conductive parts, a permanent magnet closed circuit unit consisting of at least two permanent magnet closed circuits positioned in parallel to the surface of the target, and used for applying a magnetic field to the target, and a closed circuit moving unit used for continuously moving the permanent magnet closed circuit unit in one direction along an elliptical track parallel to the surface of the target.

In the above sputtering apparatus, the target is held and insulated by the target seat. In addition, a cooling unit may be selectively installed under the target to cool the target, and a shielding unit may be selectively installed at a position above the target so as to intercept ions discharged from both the cooling unit and the target and prevent an undesired fracture of the insulating target seat due to the ions.

The planar-type magnetron sputtering apparatus of this embodiment further comprises a tension control unit controlling the tension of the permanent magnet closed circuit unit while overcoming a repulsion force acting between the permanent magnet closed circuits, and allowing the permanent magnet closed circuits to maintain a desired parallel space between the closed circuits and the back surface of the target.

### BRIEF DESCRIPTION OF THE DRAWINGS

The above and other objects, features and other advantages of various embodiments of the present invention will be more clearly understood from the following detailed description taken in conjunction with the accompanying drawings, in which:
Fig. 1a is a sectional view, showing the construction of a conventional planar-type magnetron sputtering apparatus;
Fig. 1b is a sectional view of part of a target partially and heavily etched in a sputtering process using the conventional apparatus of Fig. 1;
Fig. 2 is a view, showing the construction of part of a planar-type magnetron sputtering apparatus in accordance with the preferred embodiment of the present invention;
Fig. 3 is a bottom view of a closed circuit moving unit included in the magnetron sputtering apparatus of Fig. 2; and
Fig. 4 is a sectional view, showing the construction of each permanent magnet closed circuit included in the magnetron sputtering apparatus of Fig. 2.

### DETAILED DESCRIPTION OF THE INVENTION

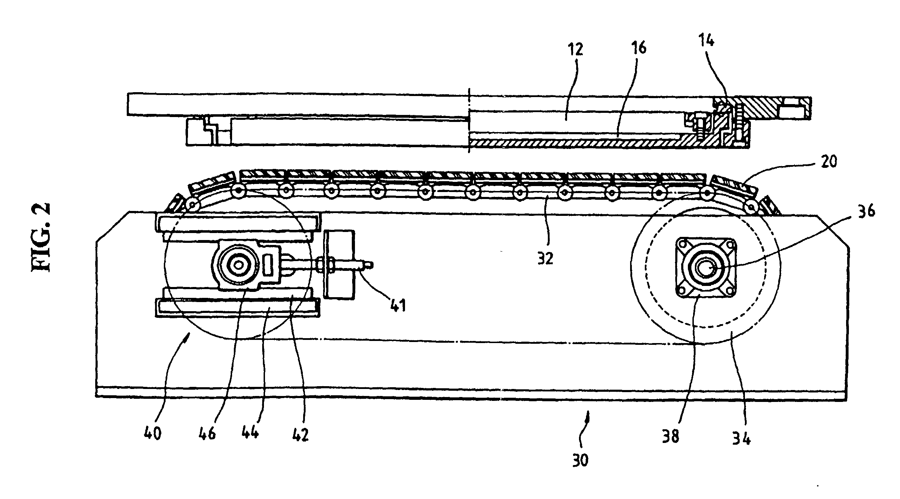

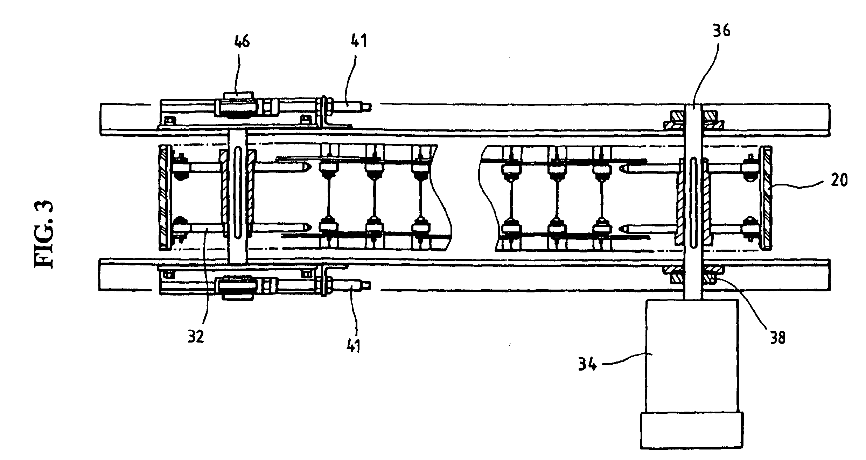

Fig. 2 is a view, showing the construction of part of a planar-type magnetron sputtering apparatus in accordance with the preferred embodiment of the present invention. Fig. 3 is a bottom view of a closed circuit moving unit included in the magnetron sputtering apparatus of Fig. 2.

As shown in the drawings, the magnetron sputtering apparatus of this embodiment comprises a target seat 14, which is made of an insulating Teflon ® material and is used for seating and holding a cathode target 12 thereon. The target 12 is a metal or ceramic target, and is used for discharging atoms to form a desired thin coating on a substrate surface through a sputtering processing using the apparatus. A cooling unit 16 is installed at a position under the target 12 so as to cool said target 12 during an operation of the apparatus. A permanent magnet closed circuit unit 20, consisting of a plurality of permanent magnet closed circuits 21, is installed under the cooling unit 16 such that the closed circuit unit 20 is spaced apart from the lower surface of the cooling unit 16 by a predetermined gap. This permanent magnet closed circuit unit 20 is used for applying a magnetic field to the target 12. The sputtering apparatus of this embodiment also comprises a closed circuit moving unit 30, which moves the closed circuit unit 20 in one direction along an elliptical track parallel to the surface of the target 12. The apparatus may be selectively provided with a tension control unit 40, which appropriately controls the tension of the circuit unit 20 while overcoming the repulsion force acting between the closed circuits of the circuit unit 20 and allows the permanent magnet closed circuits 21 of the circuit unit 20 to move in parallel to the surface of the target 12 while maintaining a desired parallel space between the closed circuits 21 and the target 12.

A substrate holder (not shown) is installed at the upper portion of the sputtering apparatus at a position above the target 12, and seats and holds a substrate thereon.

The cathode target 12 is a crystalline material, which has the same components as those of a desired thin coating to be formed on the surface of the substrate. The electrons, discharged from the target 12 in response to an electric field, collide against sputtering gas, such as argon gas (Ar), thus generating argon cations. The argon cations collide with the target 12, thus allowing the target 12 to perform a desired magnetron discharge. That is, the target 12 dislodges atoms and ions from its surface. In the sputtering process, it is possible to use targets of a variety of crystalline materials, such as metal and ceramic materials. In the present embodiment, it is possible to use metal targets of titanium (Ti), chrome (Cr), aluminum (Al), copper (Cu) or zirconium (Zr), or ceramic targets of indium tin oxide (ITO) or aluminum oxide (alumina, Al₂O₃). In order to form a desired electric field, a negative charge is applied to the target 12, while no charge or a positive charge is applied to the substrate holder positioned opposite to the target 12.

The target seat 14 surrounds the target 12 so as to hold the target 12 in addition to insulating the target 12 from surrounding conductive parts.

The cooling unit 16, positioned under the target 12, cools both the target 12 and the target seat 14 to a desired temperature lower than a predetermined reference point during a sputtering process. Of course, it should be understood that the sputtering apparatus of this embodiment may be designed to be free from such a cooling unit 16. However, it is preferable to install the unit 16 in the apparatus to improve the operational effect of the apparatus. The cooling unit 16 is also provided with a coolant circulation pipe for allowing a circulation of coolant relative to the cooling unit 16.

The permanent magnet closed circuit unit 20 forms a plurality of magnetic fields, for example, two magnetic fields, so as to allow a concentration of electrons, discharged from the target 12, on the surface of the target 12.

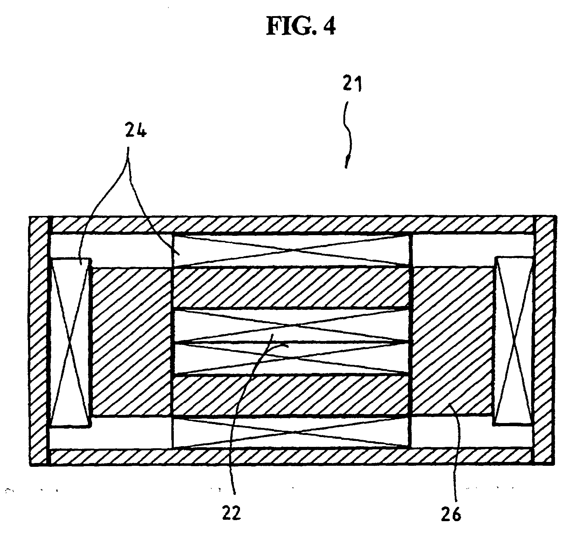

Fig. 4 is a sectional view, showing the construction of each permanent magnet closed circuit 21 included in the closed circuit unit 20 of this invention. As shown in the drawing, each permanent magnet closed circuit 21 of the circuit unit 20 comprises two first permanent magnets 22, which are closely arranged at the central portion of the closed circuit 21. Four second permanent magnets 24 are arranged in each closed circuit 21 at four positions around the two first magnets 22, with four nonmagnetic spacers 26 made of an aluminum alloy and arranged between the first and second magnets 22 and 24 so as to maintain a desired space between the first and second magnets 22 and 24. The aluminum alloy spacers 26 also lighten the weight of the closed circuit 21. In the permanent magnet closed circuit 21, the first and second permanent magnets 22 and 24 are made of a neodymium-iron based alloy (Nd-Fe alloy) or a samarium based alloy (Sm alloy), and have a surface magnetic flux density of higher than about 0.2 Tesla (2,000 Gauss).

In each permanent magnet closed circuit 21, the two first permanent magnets 22 are arranged such that their N-poles and S-poles are positioned at the same directions. On the other hand, the four second permanent magnets 24 are arranged such that an attraction force acts between the first and second magnets 22 and 24. That is, the second magnets 24 are arranged, with the S-pole of each second magnet 24 positioned to face the N-pole of an associated first magnet 22 and the N-pole of each second magnet 24 positioned to face the S-pole of an associated first magnet 22.

In the sputtering apparatus of this embodiment, the closed circuit moving unit 30 is positioned under the target 12, and is used for moving the closed circuit unit 20 in one direction along an elliptical track parallel to the surface of the target 12 during a sputtering process. As shown in Figs. 2 and 3, the closed circuit moving unit 30 comprises an attachment chain 32, with the closed circuits 21 of the circuit unit 20 regularly seated along the chain 32 to form an elliptical movable closed circuit loop. In order to move the chain 32 along with the closed circuits 21, the closed circuit moving unit 30 also comprises a motor-operated drive roller and a driven roller, with the chain 32 wrapped around the two rollers. The above drive roller of the closed circuit moving unit 30 is rotatably held by a motor shaft 36 extending from a drive motor 34, thus being rotated by the rotating force of the motor 34. An UCFL bearing unit 38 supports the drive roller around the motor shaft 36 so as to allow a smooth rotation of said drive roller.

In the sputtering apparatus of this embodiment, the tension control unit 40 appropriately controls the tension of the circuit unit 20 while overcoming the repulsion force acting between the permanent magnet closed circuits 21 of the circuit unit 20, and allows the closed circuits 21 to move in parallel to the surface of the target 12 while maintaining a desired parallel space between the closed circuits 21 and the target 12. This tension control unit 40 comprises a tension adjusting bolt 41, which controls the interval between the shafts of the drive and driven rollers of the closed circuit moving unit 30 so as to maintain a desired tension of the elliptical closed circuit loop. In order to allow a smooth rotation of the driven roller of the closed circuit moving unit 30 during a tension adjusting operation of the unit 40, the tension control unit 40 also has an UCT bearing unit 46, which holds the driven roller around a shaft. The tension control unit 40 further comprises two longitudinal guides 42 mounted along two guide brackets 44 so as to allow the UCT bearing unit 46 to be linearly movable in a desired direction under the guide of the two longitudinal guides 42.

In the present embodiment, a shielding unit may be preferably and selectively installed at a position above the target 12 so as to intercept ions discharged from both the cooling unit 16 and the target 12 and prevent an undesired fracture of the insulating target seat 14 due to the ions. In such a case, it is preferable to set the shielding unit with a height difference of about 1 mm formed between the shielding unit and the surface of the target 12.

The operational effect of the sputtering apparatus of this embodiment during a sputtering process will be described herein below.

A desired target 12, selected from metal targets of titanium (Ti), chrome (Cr), aluminum (Al), copper (Cu) or zirconium (Zr), or ceramic targets of indium tin oxide (ITO) or aluminum oxide (alumina, Al₂O₃), is primarily seated on the target seat 14. Thereafter, a selected sputtering gas, such as argon gas, is supplied into a sputtering chamber, while a high electric charge is applied to the target 12. In response to the application of the high electric charge to the target 12, the target 12 discharges electrons. The discharged electrons form a high-density electron concentrating area while performing both a swirling motion and a hopping motion on a predetermined portion of the target 12 due to the magnetic field formed by the permanent magnet closed circuit unit 20.

At the high-density electron concentrating area, the electrons collide with the argon sputtering gas, thus generating argon cations. The argon cations collide with the surface of the target 12, thus etching the target 12. When the target 12 is etched as described above, the target 12 dislodges atoms and ions from its surface. The atoms and ions from the target 12 are deposited on the entire surface of the substrate positioned opposite to the target 12, thus forming a desired thin coating on the surface of the large-scaled substrate.

During a formation of the thin coating on the entire surface of the substrate, the attachment chain 32 of the closed circuit moving unit 30 moves in one direction along the elliptical track parallel to the surface of the target 12, and so the permanent magnet closed circuits 21 of the circuit unit 20 moves in the same direction along with the chain 32.

Due to the movement of permanent magnet closed circuits 21 of the circuit unit 20, the magnetron discharge tracks, formed on the surface of the target 12 at positions corresponding to the closed circuits 21, continuously move along the surface of the target 12 in the same direction as that of the closed circuits 21. That is, the magnetron discharge tracks continuously moves from one end to the other end of the target 12 without being stopped during a sputtering process. The target 12 is thus uniformly etched on its surface without being partially and heavily etched, and allows a uniform thin coating to be formed on the entire surface of the large-scaled substrate seated on the substrate holder.

As described above, the present embodiment provides a planar-type magnetron sputtering apparatus capable of forming a uniform thin coating on the entire surface of a substrate having a large area. This sputtering apparatus has a closed circuit moving unit, which moves a plurality of permanent magnet closed circuits in one direction along an elliptical track parallel to the surface of the target during a sputtering process. The apparatus thus allows the target to be uniformly etched on its surface, and so it is possible to form a desired uniform thin coating on the entire surface of a substrate having a large area. The apparatus also improves the using efficiency of the expensive target to a desired level of higher than 60 % since the target is uniformly etched on its surface due to the unidirectional movement of the permanent magnet closed circuits.

In an operation of this sputtering apparatus, the permanent magnet closed circuits are designed to be moved in one direction at a desired high speed, and so it is possible to lengthen the expected life span of a drive motor for the permanent magnet closed circuits.

In the sputtering apparatus of this embodiment, a unidirectional motor in place of a conventional reversible motor as the drive motor, and so the target is uniformly etched on its surface for the same discharge time regardless of the portions of the target from one end to the other end during a sputtering process. The using efficiency of the expensive target is thus improved.

## Claims

1. A planar-type magnetron sputtering apparatus, comprising:
a target seat (14) used for seating and holding a target (12) thereon in addition to insulating said target (12) from surroundings;
a permanent magnet closed circuit unit (20) consisting of at least two permanent magnet closed circuits (21), and used for applying a magnetic field to said target (12); and
a closed circuit moving unit (30) used for continuously moving said permanent magnet closed circuit (21) unit in one direction along a substantially elliptical track parallel to a surface of said target (12) **characterized in that** said apparatus includes a tension control unit (40) controlling a tension of said permanent magnet closed circuit unit (20) while overcoming a repulsion force acting between said permanent magnet closed circuits (21), and allowing the permanent magnet closed circuits (21) to maintain a desired parallel space between the closed circuits and a back surface of said target (12).

2. The planar-type magnetron sputtering apparatus according to claim 1, wherein said tension control unit (40) comprises:
a tension adjusting bolt (41) controlling an interval between drive and driven shafts of said closed circuit moving unit so as to maintain a desired tension of said permanent magnet closed circuit unit (20);
a UCT bearing unit (46) holding the driven shaft of said closed circuit moving unit (30) so as to allow a smooth rotation of said driven shaft during a tension adjusting operation of the tension adjusting bolt; and
a longitudinal guide (42) mounted along a guide bracket (44) said longitudinal guide (42) being used for linearly guiding said UCT bearing unit (46) in a desired direction during a movement of the UCT bearing unit (46).

3. The planar-type magnetron sputtering apparatus according to claim 1 or claim 2, wherein said closed circuit moving unit (30) comprises:
an elliptical attachment chain (32) regularly seating said permanent magnet closed circuits (21) thereon;
a drive motor (34) generating a rotating force for moving said attachment chain (32) along with the permanent magnet closed circuits (21);
drive and driven shafts holding said attachment chain (32) while moving said chain using the rotating force of the drive motor (34); and
a UCFL bearing unit (38) supporting the drive shaft so as to allow a smooth rotation of said drive shaft.

4. The planar-type magnetron sputtering apparatus according to any preceding claim, wherein each of said permanent magnet closed circuits (21) of the closed circuit unit (20) comprises:
two first permanent magnets (22) closely arranged at a central portion of the permanent magnet closed circuit;
four second permanent magnets (24) arranged in the permanent magnet closed circuit (21) at positions around said two first permanent magnets (22); and
a plurality of nonmagnetic spacers (26) arranged between said first and second permanent magnets (22, 24) so as to maintain a desired space between the first and second permanent magnets (22, 24).

5. The planar-type magnetron sputtering apparatus according to claim 4, wherein said two first permanent magnets (22) are arranged such that their N-poles and S-poles are positioned at the same directions, and said four second permanent magnets (24) are arranged such that the S-pole of each of said second magnets (24) is positioned to face the N-pole of an associated first permanent magnet (22)and the N-pole of each of said second permanent magnets (24) is positioned to face the S-pole of an associated first permanent magnet (22), thus allowing an attraction force to act between the first and second permanent magnets (22, 24).

6. The planar-type magnetron sputtering apparatus according to claim 4, wherein each of said first and second permanent magnets (22, 24) is made of a neodymium-iron based alloy or a samarium based alloy and has a surface magnetic flux density of higher than about 0.2 Tesla (2,000 Gauss).

7. A planar-type magnetron sputtering apparatus according to claim 1 and any preceding claim when dependent on claim 1, including:
a cooling unit (16) used for cooling said target (12) with the permanent magnet closed circuit unit (20) consisting of at least two permanent magnet closed circuits (21), and spaced apart from a back surface of said target (12) by a predetermined gap, and used for applying a magnetic field to said target (12).

## Patentansprüche

1. Magnetron-Sputter-Apparat vom Planartyp, der Folgendes umfasst:
einen Target-Sitz (14), der zum Aufnehmen und Halten eines Targets (12) darauf zusätzlich zum Isolieren des Targets (12) von der Umgebung verwendet wird;
eine geschlossene Permanentmagnet-Kreislaufeinheit (20), die aus wenigstens zwei geschlossenen Permanentmagnet-Kreisläufen (21) besteht und die zum Anwenden bzw. Anlegen eines magnetischen Feldes auf bzw. an das Target (12) verwendet wird; und
eine Bewegungseinheit (30) für den geschlossenen Kreislauf, der zum kontinuierlichen Bewegen der geschlossenen Permanentmagnet-Kreislaufeinheit (21) in einer Richtung entlang einer im Wesentlichen elliptischen Spur bzw. im Wesentlichen elliptischen Pfades parallel zu der Oberfläche des Targets (12) verwendet wird, **dadurch gekennzeichnet, dass** der Apparat eine Spannungs- bzw. Zugsteuereinheit (40) enthält, die eine Spannung bzw. einen Zug der geschlossenen Permanentmagnet-Kreislaufeinheit (20) steuert, während eine Abstoßungskraft überwunden wird, die zwischen den geschlossenen Permanentmagnet-Kreisläufen (21) wirkt, und die den geschlossenen Permanentmagnet-Kreisläufen (21) erlaubt, einen gewünschten parallelen Raum zwischen den geschlossenen Kreisläufen und einer Rückfläche des Targets (12) aufrechtzuerhalten.

2. Magnetron-Sputter-Apparat vom Planartyp nach Anspruch 1, bei welchem die Spannungs-Steucreinheit (40) Foglendes umfasst:
einen Spannungs-Einstellbolzen (41), der ein Intervall zwischen treibenden und getriebenen Wellen bzw. Schaften der geschlossenen Kreislauf-Bewegungseinheit so steuert, um eine gewünschte Spannung bzw. einen gewünschten Zug der geschlossenen Permanentmagnet-Kreislaufeinheit (20) aufrechtzuerhalten;
eine UCT-Lagereinheit (46), die den getriebenen Schaft bzw. die getriebene Welle der geschlossenen Kreislauf-Bewegungseinheit (30) so hält, um eine glatte bzw. gleichmäßige Drehung des getriebenen Schaftes bzw. der getriebenen Welle während einer Spannungseinstelloperation des Spamnungseinstellbolzens zu erlauben;
eine Längsführung (42), die entlang einer Führungsklammer (44) montiert bzw. angebracht, ist, wobei die Längsführung (42) verwendet wird, um die UCT-Lagereinheit (46) linear in eine gewünschte Richtung während einer Bewegung der UCT-Lagereinheit (46) zu führen.

3. Magnetron-Sputter-Apparat vom Planartyp nach Anspruch 1 oder Anspruch 2, bei welchem die geschlossene Kreislauf-Bewegungseinheit (30) folgendes umfasst:
eine elliptische Anbringkette (32), die gleichmäßig bzw. regelmäßig die geschlossenen Permanentmagnet-Kreisläufe (21) darauf aufnimmt;
einen Treibermotor (34), der eine Drehkraft zum Bewegen der Anbringkette (32) zusammen mit den geschlossenen Permanentmagnet-Kreisläufen (21) erzeugt;
treibende und getriebene Wellen bzw. Schafte, die die Anbringkette (32) halten, während die Kette bewegt wird, wobei die Drehkraft des Treibermotors (34) verwendet wird; und
eine UCFL-Lagereinheit (38), die den treibenden Schaft bzw. treibende Welle trägt bzw. halten, um so eine gleichmäßige bzw. glatte Drehung des treibenden Schaftes bzw. der treibenden Welle zu ermöglichen.

4. Magnetron-Sputter-Apparat vom Planartyp gemäß einem vorhergehenden Anspruch, bei welchem jeder der geschlossenen Permanentmagnet-Kreisläufe (21) der geschlossenen Kreislaufeinheit (20) Folgendes umfasst:
zwei erste Permanentmagnete (22), die geschlossen bei einem zentralen Abschnitt des geschlossenen Permanentmagnet-Kreislaufs angeordnet sind;
vier zweite Permanentmagnete (24), die in dem geschlossenen Permanentmagnet-Kreislauf (21) bei Positionen um die zwei ersten Permanentmagnete (22) angeordnet sind; und
eine Vielzahl von nichtmagnetischen Abstandshaltern (26), die zwischen dem ersten und zweiten Permanentmagneten (22, 24) angeordnet sind, um so einen gewünschten Raum bzw. Zwischenraum zwischen dem ersten und zweiten Permanentmagneten (22, 24) aufrechtzuerhalten.

5. Magnetron-Sputter-Apparat vom Planartyp gemäß Anspruch 4, bei welchem die drei ersten Permanentmagnete (22) derartig angeordnet sind, dass ihre N-Pole und ihre S-Pole in dieselben Richtungen positioniert sind und die vier zweiten Permanentmagnete (24) derartig angeordnet sind, dass der Südpol eines jeden der zweiten Magnete (24) so positioniert ist, um dem N-Pol eines zugeordneten ersten Permanentmagneten (22) gegenüberzuliegen, und der N-Pol eines jeden der zweiten Permanentmagnete (24) so positioniert ist, um den S-Pol eines zugeordneten ersten Permanentmagneten (22) gegenüberzuliegen, um es so zu ermöglichen, dass eine Anziehkraft zwischen dem ersten und zweiten Permanentmagneten (22, 24) wirkt.

6. Magnetron-Sputter-Apparat vom Planartyp nach Anspruch 4, bei welchem ein jeder der ersten und zweiten Permanentmagnete (22, 24) aus eine auf Neodym-Eisen basierenden Legierung oder einer auf Samarium basierenden Legierung hergestellt ist und eine Oberflächen-Magnetfluss-Dichte hat, die größer als ungefähr 0,2 Tesla (2,000 Gauss) ist.

7. Magnetron-Sputter-Apparat vom Planartyp nach Anspruch 1 und irgendeinem vorhergehenden Anspruch, wenn er von Anspruch 1 abhängt, der Folgendes enthält:
eine Kühleinheit (16), die verwendet wird, um das Target (12) mit der geschlossenen Permanentmagnet-Kreislaufeinheit (20), die aus wenigstens zwei geschlossene Permanentmagnet-Kreisläufen (21) besteht, abzukühlen, und die von einer Rückfläche des Targets (12) um einen vorbestimmten Spalt beabstandet ist, und die zum Anwenden bzw. Anlegen eines Magnetfeldes auf bzw. an das Target (12) verwendet wird.

## Revendications

1. Appareil de pulvérisation à magnétron du type plan, comportant :
un siège pour cible (14) utilisé pour appuyer et maintenir une cible (12) sur celui-ci en plus d'isoler ladite cible (12) vis-à-vis de l'environnement,
une unité de circuits fermés d'aimants permanents (20) constituée d'au moins deux circuits fermés d'aimants permanents (21) et utilisée pour appliquer un champ magnétique sur ladite cible (12), et
une unité de déplacement de circuits fermés (30) utilisée pour déplacer en continu ladite unité de circuits fermés d'aimants permanents (21) dans une direction, le long d'une piste sensiblement elliptique parallèle à une surface de ladite cible (12), **caractérisé en ce que** ledit appareil comporte une unité de commande de tension (40) commandant une tension de ladite unité de circuits fermés d'aimants permanents (20) tout en surmontant une force de répulsion agissant entre lesdits circuits fermés d'aimants permanents (21) et permettant aux circuits fermés d'aimants permanents (21) de maintenir un espace parallèle voulu entre les circuits fermés et une surface arrière de ladite cible (12).

2. Appareil de pulvérisation à magnétron du type plan, selon la revendication 1, dans lequel ladite unité de commande de tension (40) comporte :
un boulon d'ajustement de tension (41) , commandant un intervalle entre des arbres d'entraînement et entraîné de ladite unité de déplacement de circuits fermés de manière à maintenir une tension voulue de ladite unité de circuits fermés d'aimants permanents (20)
une unité de palier UCT (46) supportant l'arbre entraîné de ladite unité de déplacement de circuits fermés (30) de manière à permettre une rotation douce dudit arbre entraîné pendant une opération d'ajustement de tension du boulon d'ajustement de tension, et
un guide longitudinal (42) monté le long d'un étrier de guide (44), ledit guide longitudinal (42) étant utilisé pour guider linéairement ladite unité de palier UCT (46) dans une direction voulue pendant un déplacement de l'unité de palier UCT (46).

3. Appareil de pulvérisation à magnétron du type plan selon la revendication 1 ou 2, dans lequel ladite unité de déplacement de circuits fermés (30) comporte
une chaîne elliptique de fixation (32) appuyant régulièrement lesdits circuits fermés d'aimants permanents (21) sur celle-ci,
un moteur d'entraînement (34) produisant une force de rotation pour déplacer ladite chaîne de fixation (32) en même temps que les circuits fermés d'aimants permanents (21), les arbres d'entraînement et entraîné supportant ladite chaîne de fixation (32) tout en déplaçant ladite chaîne en utilisant la force de rotation du moteur d'entraînement (34), et une unité de palier UCFL (38) supportant l'arbre d'entraînement de manière à permettre une rotation douce dudit arbre d'entraînement.

4. Appareil de pulvérisation à magnétron du type plan selon l'une quelconque des revendications précédentes, dans lequel chacun desdits circuits fermés d'aimants permanents (21) de l'unité de circuits fermés (20) comporte :
deux premiers aimants permanents (22) agencés de manière serrée au niveau d'une partie centrale du circuit fermé d'aimants permanents,
quatre seconds aimants permanents (24) agencés dans le circuit fermé d'aimants permanents (21) au niveau de positions situées autour desdits premiers aimants permanents (22), et
une pluralité d'écarteurs non-magnétiques (26) agencés entre lesdits premiers et seconds aimants permanents (22, 24) de manière à maintenir un espace voulu entre les premiers et seconds aimants permanents (22, 24).

5. Appareil de pulvérisation à magnétron du type plan selon la revendication 4, dans lequel lesdits deux premiers aimants permanents (22) sont agencés de telle sorte que leur pôle nord N et leur pôle sud S sont positionnés dans les mêmes directions, et lesdits quatre seconds aimants permanents (24) sont agencés de telle sorte que le pôle sud S de chacun desdits seconds aimants (24) est positionné pour être en vis-à-vis du pôle nord N d'un premier aimant permanent associé (22) et le pôle nord N de chacun desdits seconds aimants permanents (24) est positionné pour être en vis-à-vis du pôle sud S d'un premier aimant permanent associé (22), permettant ainsi qu'une force d'attraction agisse entre les premiers et seconds aimants permanents (22, 24).

6. Appareil de pulvérisation à magnétron du type plan selon la revendication 4, dans lequel chacun desdits premiers et seconds aimants permanents (22, 24) est constitué d'un alliage à base de néodyme-fer ou d'un alliage à base de samarium et a une densité de flux magnétique de surface plus élevée qu'environ 0,2 Tesla (2 000 Gauss).

7. Appareil de pulvérisation à magnétron du type plan selon la revendication 1 et l'une quelconque des revendications dépendantes de la revendication 1, incluant :
une unité de refroidissement (16) utilisée pour refroidir ladite cible (12), l'unité de circuits fermés d'aimants permanents (20) étant constituée d'au moins deux circuits fermés d'aimants permanents (21) et étant espacée d'une surface arrière de ladite cible (12) par un espace prédéterminé, et utilisée pour appliquer un champ magnétique sur ladite cible (12).
